# EUROPEAN PATENT APPLICATION

(11) **EP 2 369 653 A1**
(43) Date of publication of application: **28.09.2011**
(21) Application number: 11158997.4
(22) Date of filing: 21.03.2011
(51) Int. Cl.: H01L 35/30

(54) **Finned Radiator**

(30) Priority: 22.03.2010 IT MI20100463
(71) Applicant: Itec S.R.L., 30135 Venezia (IT)
(72) Inventor: Striuli, Alessandro, 30173, Mestre (VE) (IT); Burigo, Mario, 52048, Monte San Savino (AR) (IT)
(74) Representative: Dini, Roberto

(57) **Abstract**

The present invention relates to a radiator (1) of the type comprising:
- a first surface (10) adapted to be associated with a hot system (11), in particular to adhere to at least one portion of said hot system (11);
- at least one fin (20) extending from said first surface (10) in a manner such as to increase the area of the radiator (1) that comes into thermal contact with the surrounding fluid.

The invention is characterised in that said radiator (1) comprises conversion means (20, 30) adapted to convert the thermal energy that must be removed from the hot system (11) into electric energy, said conversion means consisting of at least one thermocouple comprising:
- a first conductive element consisting of the fin (20) of the radiator (1), and
- a second conductive element comprising at least one component (30) associated with said radiator (1) in a manner such as to extend within said at least one fin (20),

said at least one component (30) being made of a material having different thermoelectric characteristics, in particular a different Seebeck coefficient, than the radiator (1), in particular than the first surface (10) and/or the fin (20) thereof.

## Description

The present invention relates to a finned radiator according to the preamble of claim 1.

It is known in the art that heat is yielded by a system at a higher temperature, or "hot system", to a system at a lower temperature; as a consequence, in order to prevent a hot system from overheating it is a common practice to use one or more radiators associated with said "hot system".

Said radiators are usually made of a material having good thermal conductivity properties, and comprise:
- a first surface suitable for being associated with, in particular for adhering to, the hot system;
- a second surface exposed to the surrounding environment, which is generally at a lower temperature than the first surface.

Said second surface is typically so designed as to be larger than the first surface, i.e. so as to provide a number of fins adapted to considerably increase the radiator area in thermal contact with the surrounding fluid, said fluid consisting in many cases simply of air.

The use of a radiator comprising a plurality of fins allows the heat generated by the "hot system" to be conducted from the first surface, which is at a higher temperature, to the second surface, which is at a lower temperature; since the second surface is much larger than the first surface, the heat generated by the "hot system" can be dissipated into the environment more simply, quickly and effectively.

A finned radiator is thus used whenever one aims at maximising the heat exchanged between two environments at different temperatures, in particular between a "hot system" and the surrounding environment, through the finned surface of the radiator itself.

Said fins may be obtained directly on the first surface of the radiator, or they may be manufactured separately and then associated with said first surface.

As can be imagined, the performance of a finned radiator largely depends on the fins' exposed area, i.e. on the fins' shape and dimensions.

As a matter of fact, the fins may have several shapes which allow their area to be increased, thereby improving or modifying the radiator's performance; for example, the fins may be straight, conical, needle-shaped, circular, linear, tapered, and so on.

Moreover, the thermal exchange is not proportional to the fin area, in that the fin's temperature varies according to its length. In particular, if the fin is obtained directly on the first radiator surface, the two surfaces will have substantially the same temperature at the point of contact therebetween, the temperature tending to decrease along the fin body down to a value which may be associated to that of the fluid surrounding the fin ends. When the fin is subsequently associated with said first surface, it is necessary to take into account a certain resistance at the point of contact between the fin and the first surface; as a result, in this case the temperature at the fin base will be lower than in the case wherein the fin is obtained directly on the first radiator surface.

Document US2006266402 describes the use of a finned radiator in a thermoelectric generator, which comprises a plurality of thermocouples positioned between the finned radiator and a high-temperature surface associated with the hot junctions of said plurality of thermocouples.

In the present invention, the term thermocouple will refer to a device comprising a pair of conductive elements (e.g. two metal foils or wires) having different thermoelectric characteristics and being connected electrically to each other through a common end.

In the invention disclosed by document US2006266402,the finned radiator allows the temperature of the cold junctions of said plurality of thermocouples to be kept as low as possible, and the thermoelectric generator exploits a difference in temperature existing between the hot junctions and the cold junctions of said plurality of thermocouples for the purpose of producing electric energy.

In fact, when a difference in temperature exists between the region of the hot junction and the region of the cold junction, an electric potential difference can be detected wherever the circuit is opened, in particular between the free ends of the thermocouple at the cold junction thereof; said electric potential value is a direct function of the temperature difference.

This phenomenon is known as "Seebeck effect".

In the thermocouples, the thermoelectric generator described in document US2006266402 uses materials having low thermal conductivity, in particular it uses pairs of P-type and N-type doped semiconductive materials. As a consequence, the two conductors have opposite-sign Seebeck coefficients, since one material conducts electrically by moving negative charges (electrons) and the other material conducts electrically by moving positive charges (holes).

However, it has been noted that such a thermoelectric generator design involves a number of problems, mainly due to the fact that it proves to be rather complex. Consequently, this complexity implies more difficulties in assembling the thermoelectric generator, resulting in increased production costs.

A further drawback of the thermoelectric generator described in document US2006266402 is that the radiator employed therein is only used for keeping the temperature of the cold junctions of the plurality of thermocouples as low as possible; this does not allow the potentialities of the radiator to be fully exploited, so that it can produce electric current on its own. In particular, the radiator associated with the thermoelectric generator described in document US2006266402 is used in a special way; in fact, it is not used for cooling a hot system from which heat must be removed quickly, but for keeping the temperature of the cold junctions of a plurality of thermocouples as low as possible. As a result, it is clear that such a use of a radiator is inefficient and inadequate.

In this frame, it is the main object of the present invention to overcome the known drawbacks of the prior art.

It is a further object of the present invention to provide a radiator which can be manufactured in a simple and effective way, in particular without incurring in excessive production costs, and which can be used for producing electric current, so that its potentialities are fully exploited.

Such objects are achieved by the present invention through a finned radiator incorporating the features set out in the annexed claims, which are intended as an integral part of the present description.

Further objects, features and advantages of the present invention will become apparent from the following detailed description and from the annexed drawings, which are supplied by way of non-limiting example, wherein:

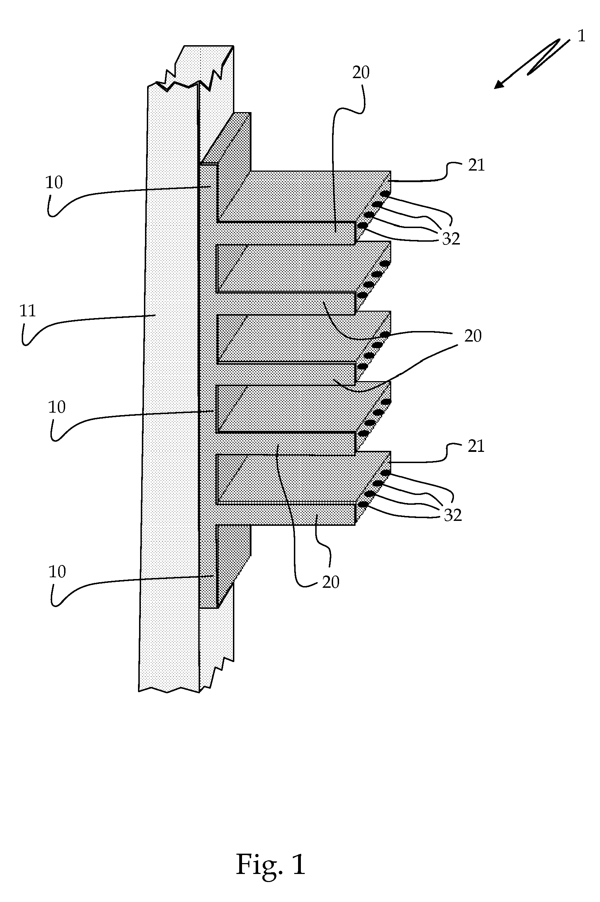

- Fig. 1 is a perspective view of a finned radiator according to the present invention;
- Figs. 2a and 2b are a sectional side view and a front view, respectively, of the radiator of Fig. 1;
- Figs. 3a and 3b are schematic views of a first and a second embodiments, respectively, of the radiator according to the present invention.

Said description and said drawings are to be considered as non-limiting examples.

The annexed drawings show a radiator according to the present invention, designated as a whole by reference numeral 1.

Said radiator 1 is of the type comprising:
- a first surface 10 suitable for being associated with a hot system 11;
- at least one fin 20 extending from said first surface 10 in a manner such as to increase the area of the radiator 1 that comes into thermal contact with the surrounding fluid.

As can be seen in the annexed drawings, said first surface 10 is essentially so designed as to constitute a base for associating the radiator 1 with the hot system 11; preferably, said first surface 10 has such shapes and dimensions as to adhere to at least one portion of said hot system 11.

The association between the first surface 10 and the hot system 11 is accomplished through fixing means known in the art.

In addition, the shape of the fins 20 may be different and such as to allow the thermal energy of the hot system 11 to be dissipated.

In accordance with the present invention, said radiator 1 comprises conversion means 20, 30 adapted to convert the thermal energy to be removed from the hot system 11 into electric energy.

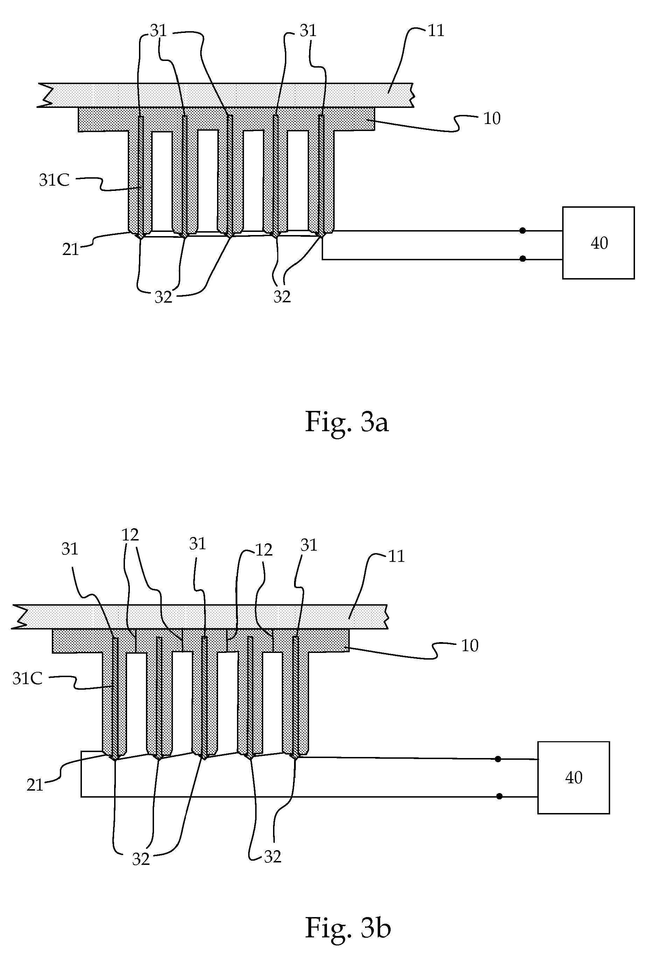

The electric energy thus obtained may then be absorbed by further means, such as a generic electric device or system schematically represented by a block 40 in Figs. 3a and 3b; in this way, the electric energy transferred to the block 40 will correspond to the quantity of thermal energy transformed through the Seebeck effect. It is apparent that electric energy absorption can be attained by storing the electric energy into a battery, or by directly using the generated electric energy.

The conversion means that allow converting the thermal energy accumulated by the hot system 11 into electric energy consist of at least one thermocouple comprising:
- a first conductive element consisting of the fin 20 of the radiator 1, and
- a second conductive element comprising at least one component 30 (e.g. a sheet-metal foil or a wire) associated with said radiator 1 in a manner such as to extend within said at least one fin 20.

Said at least one component 30 is made of a material whose thermoelectric characteristics are different from those of the radiator 1, in particular of the first surface 10 and/or of the fin 20 thereof.

In a preferred embodiment, the radiator 1 is made of an electrically conductive material of the N type and said at least one component 30 is made of an electrically conductive material of the P type, so that the two conductive materials have opposite-sign Seebeck coefficients. In particular, the first surface 10 and/or the fin 20 of the radiator 1 are made of aluminium and said at least one component 30 is made of a doped material of the P type.

The study of the thermoelectric properties of materials is currently going through a very interesting stage. Much research is being done for the purpose of finding and/or synthesising new materials having increasingly interesting thermoelectric properties, in particular having higher Seebeck coefficients. Both the theory and the first experimental results have shown that the expectations of making available new materials with improved thermoelectric properties are well-founded.

Consequently, it will also be possible to manufacture the radiator 1 according to the present invention with materials that will be available in the near future, seeking an optimal compromise between thermal properties (thermal conductivity) and thermoelectric properties (Seebeck coefficient).

In particular, the research is now focused on the use of bismuth added with antimony, aluminium and lead, and the studies are essentially addressing the doping of these materials by inserting into the reticular structure of such materials or of alloys thereof (variously assorted) atoms having dimensions much different from those present in the alloy itself, aiming at distorting in a controlled manner the geometry of the reticular structure of such metals.

According to the present invention, said at least one component 30 comprises:
- a first end 31;
- a body 31C extending within the fin 20;
- a second end 32 coming out from the coldest point of the fin 20, in particular from an end portion 21 of the fin 20.

The radiator 1 is in electric contact with said at least one component 30 through a common junction, which provides the electric contact between the first end 31 of the component 30 and the radiator 1.

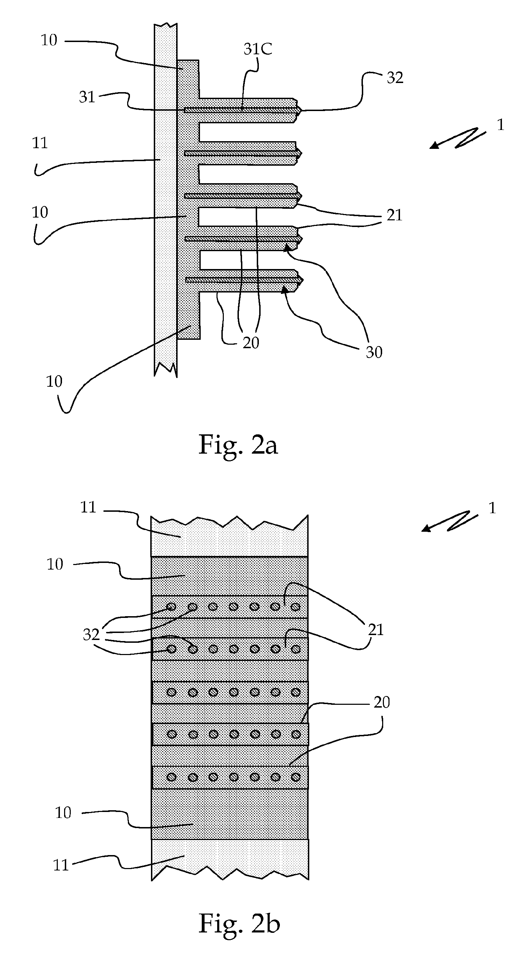

As can be seen in particular in Fig. 2a, said electric contact is obtained through a junction between said first end 31 and the first surface 10 of the radiator 1; this allows the common junction to lie as close as possible to the hot system 11, so that its operating temperature is similar to that of said hot system 11.

As an alternative, said electric contact may be obtained through a junction between the first end 31 and the fin 20, in particular a portion of the fin 20 which is close to the first surface 10 of the radiator 1.

It should be noted that the common junction may also be defined as "hot junction", in that its operating temperature is higher than the temperature of the second end 32 of the component 30 and of the end portion 21 of the fin 20, which may also be defined as "cold ends" or "free ends".

Furthermore, the body 31C of the component 30 may be electrically insulated from the material of the first surface 10 and/or of the fin 20, in particular by means of an insulating material with which said body 31C is coated, e.g. a plastic sheath.

The radiator 1 preferably comprises a plurality of fins 20, each fin 20 of said plurality of fins 20 being associated with at least one respective component 30; in accordance with the present invention it is clear that, in fact, each fin 20 may be associated with a plurality of components 30.

Fig. 3a shows a first embodiment of the radiator 1 according to the present invention.

In said first embodiment, the radiator 1 comprises a plurality of fins 20 wherein both the end portions 21 of at least two fins 20 and the second ends 32 of the components 30 of said at least two fins (20) are connected to each other. The electric energy thus generated is then absorbed by further means, such as a generic electric device (or system), represented by the block 40.

Consequently, in the first embodiment the "cold ends" of each conductor (fin 20 and component 30) of the same type of each thermocouple are electrically connected to one another; hence, the thermocouples are connected in parallel, with all "cold ends" at the same potential.

This solution offers the advantage of generating electric power with maximum current and minimum voltage; in addition, such a solution also provides the advantage that it does not require any electric insulation between the various electric contacts of each first end 31 and the radiator 1 (between the "hot junctions" of the various thermocouples), and therefore it is possible to create a radiator 1 which is electrically connected as a whole, i.e. which does not have to be sectioned electrically in multiple parts or blocks.

Fig. 3b shows a second embodiment of the radiator 1 according to the present invention. In this embodiment, the end portion 21 of at least one fin 20 is electrically connected to the second end 32 of the component 30 of another fin 20, in particular of an adjacent fin 20; moreover, in this embodiment the radiator 1 comprises insulating elements 12 which allow each electric contact ("hot junction") between the first end 31 of the component 30 and the radiator 1 to be kept electrically insulated from the other ones, i.e. from the other "hot junctions" of the various thermocouples.

As a result, in the second embodiment the "cold ends" of each conductor (fin 20 and component 30) are connected in series.

In comparison with the embodiment of Fig. 3a, the solution of Fig. 3b allows to increase voltage to the detriment of current.

Since the radiator 1 according to the present invention may comprise a plurality of fins 20, and each fin may comprise a plurality of components 30, a different combination of series and parallel connections may be provided in order to determine, the generated power being equal, the desired current/voltage combination. For example, two or more components 30 included in each fin 20 may be connected together in parallel so as to obtain a plurality of groups of thermocouples for each fin 20 or for groups of contiguous fins 20, wherein said groups of thermocouples can be connected in series to one another; this will allow sectioning the body of the radiator 1 into smaller areas, in particular through a plurality of insulating elements 12.

The features and advantages of the radiator according to the present invention are apparent from the above description.

In particular, the present invention allows said radiator 1 to be manufactured in a simple and effective manner, without incurring in excessive production costs.

A further advantage offered by the present invention is that the radiator 1 can be used for producing electric current, so as to fully exploit its potentialities. In fact, the radiator 1 according to the present invention can be used for both its classic function of dissipating the heat generated by a "hot system" into the environment in a simple, quick and effective way, and as a thermoelectric generator adapted to produce electric energy. As a result, the radiator 1 according to the present invention allows cooling the "hot system" associated therewith while at the same time recovering energy, thereby improving the overall efficiency of the system.

It is however clear that many changes may be made to the radiator according to the present invention, and that in its practical implementation the various components may have different shapes and arrangements or be replaced with other technically equivalent elements without departing from the novelty spirit of the inventive idea.

Among all possible variations, the radiator 1 may be so designed as to comprise auxiliary cooling means (not shown in the drawings) adapted to keep the end portion 21 of the fin 20 and the second end 32 of the component 30 at an adequate temperature. Said auxiliary cooling means may be supplied with energy produced by the radiator (1) and may comprise means adapted to convey a cooling fluid, in particular a current of air, into the space between said fins 20 and/or onto a proximal surface of the end portion 21 and of the second end 32. For example, said auxiliary cooling means may comprise a fan (not shown in the drawings) adapted to convey air into the space between said fins 21 and/or onto said end portion 21 and second end 32.

According to another possible variant (not shown in the drawings), the radiator 1 is so designed that both the end portions 21 of the fins 20 and the second ends 32 of the components 30 are electrically connected to one another, and the potential difference is taken at the first ends 31 of the components 30.

In a further variant (not shown in the drawings), the radiator 1 is so designed that the end portions 21 of the fins 20, the second ends 32 of the components 30 and the first ends 31 of the components 30 are electrically connected to one another, and the potential difference is taken at an intermediate point of the circuit, i.e. on the body 31C of the components 30.

It can therefore be easily understood that the present invention is not limited to the above-described finned radiator, but may be subject to many modifications, improvements or replacements of equivalent parts and elements without departing from the inventive idea, as clearly specified in the following claims.

## Claims

1. A radiator (1) of the type comprising:
- a first surface (10) adapted to be associated with a hot system (11), in particular to adhere to at least one portion of said hot system (11);
- at least one fin (20) extending from said first surface (10) in a manner such as to increase the area of the radiator (1) that comes into thermal contact with the surrounding fluid,
**characterised in that**
said radiator (1) comprises conversion means (20, 30) adapted to convert the thermal energy that must be removed from the hot system (11) into electric energy, said conversion means consisting of at least one thermocouple comprising:
- a first conductive element consisting of the fin (20) of the radiator (1), and
- a second conductive element comprising at least one component (30) associated with said radiator (1) in a manner such as to extend within said at least one fin (20),
said at least one component (30) being made of a material having different thermoelectric characteristics, in particular a different Seebeck coefficient, than the radiator (1), in particular than the first surface (10) and/or the fin (20) thereof.

2. A radiator (1) according to claim 1, **characterised in that** said radiator (1) is made of an electrically conductive material of the N type and said at least one component (30) is made of an electrically conductive material of the P type.

3. A radiator (1) according to claim 2, **characterised in that** the first surface (10) and/or the fin (20) of the radiator (1) are made of aluminium and said at least one component (30) is made of a doped material of the P type.

4. A radiator (1) according to one or more of the preceding claims, **characterised in that** said at least one component (30) comprises:
- a first end (31);
- a body (31 C) extending within the fin (20);
- a second end (32) coming out from the coldest point of the fin (20), in particular from an end portion (21) of the fin (20).

5. A radiator (1) according to claim 4, **characterised in that** the radiator (1) is in electric contact with the component (30) through a common junction which provides the electric contact between the first end (31) of the component (30) and the radiator (1).

6. A radiator (1) according to claim 5, **characterised in that** said electric contact is obtained through a junction between said first end (31) and the first surface (10) of the radiator (1).

7. A radiator (1) according to claim 5, **characterised in that** said electric contact is obtained through a junction between said first end (31) and the fin (20), in particular a portion of the fin (20) which is close to the first surface (10) of the radiator (1).

8. A radiator (1) according to claim 4, **characterised in that** said body (31C) of the component (30) is electrically insulated from the material of the first surface (10) and/or of the fin (20), in particular by means of an insulating material with which said body (31C) is coated.

9. A radiator (1) according to one or more of the preceding claims, **characterised by** comprising a plurality of fins (20), each fin (20) of said plurality of fins (20) being associated with at least one respective component (30).

10. A radiator (1) according to claim 9, **characterised in that** the end portions (21) of at least two fins (20) are electrically connected to each other, and the second ends (32) of the components (30) of said at least two fins (20) are electrically connected to each other as well.

11. A radiator (1) according to claim 9, **characterised in that** the end portion (21) of at least one fin (20) is electrically connected to the second end (32) of the component (30) of another fin (20), in particular of an adjacent fin (20), said radiator (1) comprising insulating elements (12) which allow each electric contact between the first end (31) of the component (30) and the radiator (1) to be kept electrically insulated from the other ones.

12. A radiator (1) according to one or more of claims 10 to 11, **characterised in that** both the end portions (21) of the fins (20) and the second ends (32) of the components (30) are electrically connected to one another, and the potential difference is taken at the first ends (31) of the components (30).

13. A radiator (1) according to one or more of claims 10 to 11, **characterised in that** both the end portions (21) of the fins (20) and the second ends (32) of the components (30) are electrically connected to one another, and the potential difference is taken at the body (31C) of the components (30).

14. A radiator (1) according to one or more of the preceding claims, **characterised in that** said radiator (1) comprises auxiliary cooling means adapted to keep said fin (20) and said component (30), in particular the end portion (21) of the fin (20) and the second end (32) of the component (30), at an adequate temperature.

15. A radiator (1) according to the preceding claim, **characterised in that** said auxiliary cooling means are supplied with energy produced by the radiator (1).
